# EUROPEAN PATENT APPLICATION

(11) **EP 3 690 537 A1**
(43) Date of publication of application: **05.08.2020**
(21) Application number: 18849418.1
(22) Date of filing: 01.08.2018
(51) Int. Cl.: G02F 1/1343, G02F 1/1333

(54) **ARRAY SUBSTRATE AND MANUFACTURING METHOD THEREOF, AND DISPLAY DEVICE**

(30) Priority: 29.09.2017 CN 201710909996
(71) Applicant: BOE Technology Group Co., Ltd., Beijing 100015 (CN); Beijing BOE Display Technology Co., Ltd., Beijing 100176 (CN)
(72) Inventor: DONG, Ting, Beijing 100176 (CN); QU, Yingying, Beijing 100176 (CN); CHEN, Yifu, Beijing 100176 (CN); LIU, Deqiang, Beijing 100176 (CN); ZHOU, Jian, Beijing 100176 (CN); YANG, Jian, Beijing 100176 (CN)
(74) Representative: Klunker IP Patentanwälte PartG mbB
(86) International application number: PCT/CN2018/098089
(87) International publication number: WO 2019/062320

(57) **Abstract**

An array substrate, a manufacturing method thereof and a display device are provided, the array substrate includes a first electrode (1), a second electrode (2) and an insulating layer (4) between the first electrode (1) and the second electrode (2), the second electrode (2) includes a plurality of electrode groups (22), and the electrode group (22) includes electrode strips (21) and an insulated passivation wall (3) sandwiched between the electrode strips (21). The array substrate has a high transmittance.

## Description

### CROSS-REFERENCE TO RELATED APPLICATIONS

This application claims the benefit of Chinese patent application No. 201710909996.1 filed on September 29, 2017, which is hereby entirely incorporated by reference as a part of the present application.

### TECHNICAL FIELD

Embodiments of the present disclosure relate to an array substrate, a manufacturing method of the array substrate and a display device.

### BACKGROUND

At present, users have more and more strict requirements on the energy consumption level of ultra high-definition display products, so the requirement on the transmittance of display panels is higher and higher. Advanced super dimensional switching (ADS) technology is a technology in which both a first electrode and a second electrode are in the array substrate. Currently, the display products adopting the ADS technology improve the transmittance from the aspects of improving a color filter, a polarizer, liquid crystals, a pixel design or an electrode structure or the like.

### SUMMARY

The embodiments of the present disclosure provide an array substrate, a manufacturing method of the array substrate and a display device. The embodiments of the present disclosure improves the transmittance of a display product.

At least one embodiment of the present disclosure provides an array substrate which includes a base substrate, a first electrode and a second electrode which are on the base substrate, and an insulating layer between the first electrode and the second electrode; one of the first electrode and the second electrode is a pixel electrode and the other one of the first electrode and the second electrode is a common electrode; the second electrode includes a plurality of electrode groups, and each of the plurality of electrode groups includes electrode strips and an insulated passivation wall sandwiched between the electrode strips.

For example, in a direction perpendicular to a surface that is included by the base substrate and faces the insulating layer, the first electrode is between the base substrate and the second electrode; and in a same electrode group among the plurality of electrode groups, an arrangement direction of the electrode strips and the passivation wall is parallel to the surface of the base substrate and overlap regions are between orthographic projections of the electrode strips on the base substrate and an orthographic projection of the passivation wall on the base substrate.

For example, included angles are between a plane where the base substrate is located and surfaces where the electrode strips contact the passivation wall in each of the plurality of electrode groups, and the included angles are acute angles.

For example, in a same electrode group among the plurality of electrode groups, the passivation wall includes inclined lateral surfaces respectively covered by the electrode strips, and the inclined lateral surfaces of the same passivation wall have different inclination directions.

For example, the electrode strips in a same electrode group among the plurality of electrode groups are disconnected from each other on a top of the passivation wall; and the top of the passivation wall is an end which is included by the passivation wall and faces away from the base substrate.

For example, the electrode strips in the same electrode group are directly electrically connected with each other.

For example, the electrode strips in the same electrode group are electrically connected with each other through a conductive structure.

For example, a concave space is between adjacent passivation walls that adjacent electrode groups among the plurality of electrode groups respectively include.

For example, adjacent electrode strips that the adjacent electrode groups respectively include are disconnected from each other in the concave space.

For example, the second electrode includes a surface close to the base substrate and another surface away from the base substrate which have a same width.

For example, cross-sections of the electrode strips are in a shape of a parallelogram in a direction perpendicular to the base substrate and in a direction perpendicular to an extension direction of each of the electrode strips.

For example, in a direction perpendicular to the base substrate, a size of the passivation wall of each of the plurality of electrode groups is the same with a size of each of the electrode strips.

For example, in a direction parallel to a surface that is included by the base substrate and faces the insulating layer, a width of each of the electrode strips is 0.5 - 1.2 µm.

For example, a distance between the electrode strips adjacent to each other in a same electrode group among the plurality of electrode groups is 1.8 - 3.4 µm.

For example, a distance between adjacent electrode groups among the plurality of electrode groups is 5.2 - 5.6µm.

For example, the insulating layer and the passivation wall form a one-piece structure.

At least one embodiment of the present disclosure further provides a manufacturing method of the array substrate, and the method includes: forming a first electrode on a base substrate; forming an insulating layer on the first electrode; and forming a second electrode on the insulating layer, wherein one of the first electrode and the second electrode is a pixel electrode and the other one of the first electrode and the second electrode is a common electrode; the second electrode includes a plurality of electrode groups, and each of the plurality of electrode groups includes electrode strips and a passivation wall sandwiched between the electrode strips

At least one embodiment of the present disclosure further provides a display device which includes an opposite substrate, the array substrate according to any one of the above embodiments, and liquid crystals between the opposite substrate and the array substrate.

For example, in a direction perpendicular to a surface that is included by the base substrate and faces the insulating layer, the first electrode is between the base substrate and the second electrode; and in a same electrode group among the plurality of electrode groups, an arrangement direction of the electrode strips and the passivation wall is parallel to the surface of the base substrate and overlap regions are between orthographic projections of the electrode strips on the base substrate and an orthographic projection of the passivation wall on the base substrate.

### BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
FIG. 1 is a schematic structural view of an array substrate;
FIG. 2 is a schematic structural sectional view of partial structures in the array substrate provided by at least one embodiment of the present disclosure;
FIG. 3a is a schematic structural sectional view of the array substrate provided by at least one embodiment of the present disclosure;
FIGS. 3b and 3c are schematic top views of partial structures in the array substrate as shown in FIG 3a;
FIG 4 is a schematic diagram illustrating the dimensioning on the array substrate provided by at least one embodiment of the present disclosure;
FIG 5 is a schematic diagram illustrating the dimensioning on an array substrate in a comparative example;
FIG 6 is a schematic diagram illustrating an electric field distribution of the array substrate in the comparative example;
FIG. 7 is a simulated diagram illustrating liquid crystal deflection of the array substrate in the comparative example;
FIG 8 is a simulated diagram illustrating the liquid crystal deflection of the array substrate provided by at least one embodiment of the present disclosure;
FIG. 9 is a voltage-transmittance (VT) curve comparison chart of the array substrate provided by at least one embodiment of the present disclosure and the array substrate in the comparative example;
FIG 10 is a flowchart of a manufacturing method of the array substrate, provided by at least one embodiment of the present disclosure; and
FIG 11 is a schematic structural view of a display device provided by at least one embodiment of the present disclosure.

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the object which is described is changed, the relative position relationship may be changed accordingly.

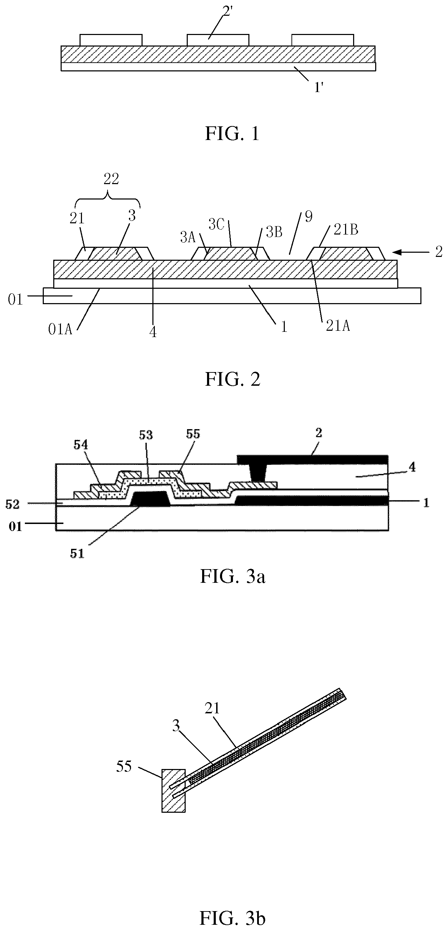

FIG. 1 is a schematic structural view of an array substrate. As shown in FIG 1, the array substrate includes a common electrode 1', an insulating layer covering the common electrode 1', and a pixel electrode 2' disposed on the insulating layer, and the pixel electrode 2' includes a plurality of pixel electrode strips tiled on the insulating layer.

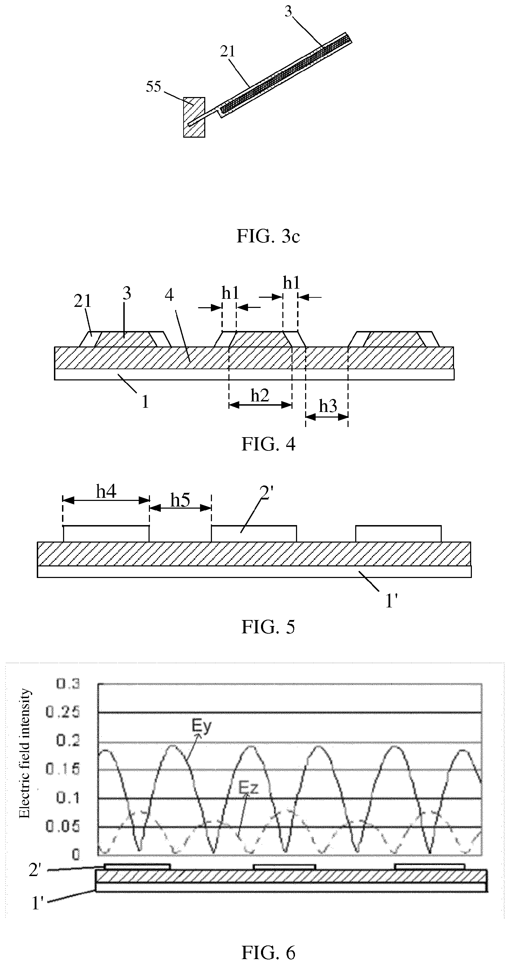

The inventors of the present application have found that: in an ADS display product (which, for instance, includes the array substrate as shown in FIG 1), a horizontal electric field is formed by the pixel electrode and the common electrode and is adopted to drive liquid crystal molecules to deflect so as to form a display image. As shown in FIG 6, the ADS electric field produced by the structure as shown in FIG. 1 includes a horizontal component Ey effective to the deflection of the liquid crystal molecules and a vertical component Ez non-effective to the deflection of the liquid crystal molecules; Ey is strong at edges of the pixel electrode strips and is weak at both middle portions of the pixel electrode strips and intermediate positions between adjacent pixel electrode strips, and Ez is strong at both the middle portions of the pixel electrode strips and the intermediate positions between the adjacent pixel electrode strips and is weak at the edges of the pixel electrode strips. Therefore, the transmittance (namely light transmittance) of the ADS display product as shown in FIG 1 changes along with the positions of the pixel electrode strips. In general, the transmittance is maximum at the edges of the pixel electrode strips and is very low at both the middle portions of the pixel electrode strips and the intermediate position between two adjacent pixel electrode strips.

At least one embodiment of the present disclosure provides an array substrate. As shown in FIG 2, the array substrate includes a base substrate 01, a first electrode 1 and a second electrode 2 which are on the base substrate 01 and in different layers, and an insulating layer 4 disposed between the first electrode 1 and the second electrode 2. The first electrode 1 is disposed between the base substrate 01 and the second electrode 2 in a direction perpendicular to a surface 01A which is included by the base substrate 01 and faces the insulating layer 4; the second electrode 2 includes a plurality of electrode groups 22, each electrode group 22 includes electrode strips 21 and an insulated passivation wall 3 (for instance, the passivation wall 3 is formed of an insulating material) sandwiched between the electrode strips 21; orthographic projections on the base substrate 01 and of the adjacent electrode strips 21 overlap an orthographic projection on the base substrate 01 and of the passivation wall 3 disposed between the adjacent electrode strips 21; and an arrangement direction of the adjacent electrode strips 21 and the passivation wall 3 is parallel to the surface 01A that is included by the base substrate 01 and faces the insulating layer 4. For instance, the first electrode 1 is a continuous block electrode; and orthographic projections, on a plane where the first electrode 1 is located, of the plurality of electrode groups 22 in the second electrode 2 fall within a region where the first electrode 1 is located.

In the embodiments of the present disclosure, one of the first electrode 1 and the second electrode 2 is a pixel electrode and the other is a common electrode. For instance, the first electrode 1 is the common electrode and the second electrode 2 is the pixel electrode, or the first electrode 1 is the pixel electrode and the second electrode 2 is the common electrode, in which case, a distance between the common electrode and a data line in the array substrate is large, thereby being favorable to improve the transmittance at the edge of the common electrode.

In at least one embodiment of the present disclosure, both the second electrode 2 and the first electrode 1 are disposed in the array substrate; the second electrode 2 includes electrode strips 21 (namely strip electrodes); and the passivation wall 3 adjacent to the electrode strip 21 is disposed on one side of the electrode strip 21. Therefore, the structure of the second electrode 2 in the embodiments can be considered as that: the second electrode 2 includes the plurality of electrode groups 22; each electrode group 22 includes a plurality of electrode strips 21 (for instance, two electrode strips 21), and the passivation wall 3 is sandwiched between the adjacent electrode strips 21 in the same electrode group 22.

In the embodiments of the present disclosure, the vertical component Ez of the electric field at a position of the passivation wall 3 (namely at a middle portion of the electrode group 22) is weak, and the vertical component Ez of the electric field between adjacent electrode groups 22 is also weak; a new small electric field with dense electric field lines is formed between the electrode strips 21, which are respectively formed on inclined surfaces of the passivation wall 3, and the first electrode 1; and an additional horizontal component provided by the small electric field enhances the horizontal component Ey of the electric field at the positions of the electrode strips 21 (namely edges of the electrode group 22). Therefore, the electric fields formed in the array substrate provided by the embodiments of the present disclosure not only include a horizontal electric field formed between each electrode group 22 and the first electrode 1 but also include a new horizontal electric field formed between the plurality of (for instance, two) electrode strips 21 in each electrode group 22 and the first electrode 1. The formed new horizontal electric field can increase the deflection angle of liquid crystals and then improve the transmittance.

As an optional example in the embodiments of the present disclosure, included angles are formed between contact surfaces where the electrode strips 21 contact the passivation wall 3 in each electrode group 22 and a plane where the base substrate 01 is located, and the included angles are acute angle.

As an optional example in the embodiments of the present disclosure, in the same electrode group 22, the passivation wall 3 includes inclined lateral surfaces 3A and 3B respectively covered by the electrode strips 21; the inclined lateral surfaces 3A and 3B are inclined relative to the surface 01A of the base substrate 01; and the inclined lateral surfaces 3A and 3B of the same passivation wall 3 have different inclination directions, for instance, opposite inclination directions.

As an optional example in the embodiments of the present disclosure, the electrode strips 21 included by the same electrode group 22 are disconnected from each other on a top 3C of the passivation wall 3, and the top 3C of the passivation wall 3 is one end of the passivation wall 3 away from the base substrate 01. Because the adjacent electrode strips 21 (namely no other electrode strip 21 is between the adjacent electrode strips 21) included by the same electrode group 22 are disconnected at the top 3C, the overlap area between the orthographic projections on the base substrate 01 of the electrode strips 21 in the electrode group 22 and the orthographic projection on the base substrate 01 of the first electrode 1 is small, thereby being favorable for reducing a storage capacitance.

As an optional example in the embodiments of the present disclosure, a concave space 9 is disposed between adjacent passivation walls 3 of adjacent electrode groups 22. For instance, FIG 2 shows three electrode groups 22, and each electrode group includes one passivation wall 3; the electrode group 22 on the left is adjacent to the electrode group 22 in the middle; the passivation wall 3 in the electrode group 22 on the left is adjacent to the passivation wall 3 of the electrode group 22 in the middle (namely no other passivation wall 3 is disposed between the two passivation walls 3); and the concave space 9 is disposed between the two passivation walls 3.

As an optional example in the embodiments of the present disclosure, adjacent electrode strips 21 that the adjacent electrode groups 22 respectively include are disconnected from each other in the concave space 9. For instance, as shown in FIG 2, the right electrode strip 21 in the electrode group 22 on the left is adjacent to the left electrode strip 21 in the electrode group 22 in the middle, and the two adjacent electrode strips 21 are disconnected from each other.

FIG. 3a corresponding to at least one embodiment of the present disclosure shows partial structures of the array substrate. As shown in FIG 3a, there are sequentially provided on the base substrate 01 from the bottom up: the first electrode 1, the insulating layer 4 and the second electrode 2; and the insulating layer 4 is disposed between the first electrode 1 and the second electrode 2 so that the first electrode 1 and the second electrode 2 can be insulated from each other. As shown in FIG 2, the second electrode 2 includes the plurality of electrode groups 22; for instance, each electrode group 22 includes two adjacent electrode strips 21; and in a direction parallel to the plane where the base substrate 01 is located, the passivation wall 3 is sandwiched between the two electrode strips 21. It should be noted that the passivation wall 3 and the insulating layer 4 are formed of a transparent insulating material, which does not affect the transmittance of the array substrate.

In a situation where the second electrode 2 is the pixel electrode, FIG 3a corresponding to at least one embodiment of the present disclosure also shows a connection mode between the second electrode 2 and a thin-film transistor. For instance, as shown in FIG. 3, the thin film transistor includes a gate electrode 51, a gate insulating layer 52, an active layer 53, a source electrode 54 and a drain electrode 55, and the second electrode 2 is electrically connected with the drain electrode 55 via a through hole. In other embodiments, for example, the second electrode 2 serving as the pixel electrode is electrically connected with the drain electrode 55 directly or is electrically connected with the drain electrode 55 through a conductive component.

For instance, the electrode strips 21 in the same electrode group 22 are directly electrically connected with each other; or the electrode strips 21 in the same electrode group 22 are electrically connected with each other through a conductive structure.

Both FIG 3b and FIG 3c show a connection mode between the drain electrode 55 of the thin film transistor and two adjacent electrode strips 21 (namely the electrode strips 21 respectively disposed on two sides of the same passivation wall 3) in the same electrode group. For instance, as shown in FIG. 3b, the two adjacent electrode strips 21 in each electrode group are respectively electrically connected to the drain electrode 55, so that the two electrode strips 21 are electrically connected with each other through the drain electrode 55 (one example of the above conductive structure); or for instance, as shown in FIG 3c, one electrode strip 21 in the same electrode group is electrically connected to the drain electrode 55 via being connected to the other electrode strip 21 in the electrode group at a position close to the drain electrode 55, so the electrode strips 21 in the same electrode group are directly electrically connected with each other.

It should be noted that the second electrodes 2 disposed in different subpixels (for instance, the second electrodes 2 electrically connected with different thin film transistors) in one array substrate can be all in the form of the above electrode group 22, or only a part is in the form of the above electrode group 22 and the other part is in other forms, which can be selected according to actual demands.

As an optional example of the embodiments of the present disclosure, the insulating layer 4 and the passivation wall 3 form a one-piece structure. That is to say, the insulating layer 4 and the passivation wall 3 is formed by a same material via a same mask, for example. For instance, the insulating layer 4 and the passivation wall 3 in the embodiments of the present disclosure are formed by adoption of a half-tone mask process. Thus, the processing steps can be saved, without increasing the product cost.

In one embodiment, in the direction parallel to the surface 01A of the base substrate 01, the second electrode 2 includes a surface 21A close to the base substrate 01 and a surface 21B away from the base substrate 01 which have a same width.

It can be seen from the sectional view in FIG. 3 that: an orthographic projection area of a surface that is included by the passivation wall 3 and faces away from a light incident side (namely an incident side where light emitted by a backlight source is incident) falls into and is less than an orthographic projection area of another surface that is included by the passivation wall 3 and is close to the light incident side, that is, a cross-section of the passivation wall 3 is a trapezoid. The function of such design is that: in the process of subsequently forming the electrode strips 21, the electrode strips 21 are formed by being attached to the contact surfaces of the passivation wall 3 respectively, and the size of the electrode strips 21 formed like this is more accurate. In other embodiments, for example, the cross-section of the passivation wall 3 is a triangle or other similar shapes with inclined lateral surfaces.

In one embodiment, in a direction perpendicular to the base substrate 01 and perpendicular to an extension direction of the electrode strip 21, a cross-section of the electrode strip 21 is a parallelogram. That is to say, the surface 21B that is included by the electrode strip 21 and faces away from the base substrate 01 is parallel to the surface 21A that is included by the electrode strip 21 and is close to the base substrate 01, and a lateral surface that is included by the electrode strip 21 and faces away from the passivation wall 3 is parallel to a lateral surface that is included by the electrode strip 21 and close to the passivation wall 3.

As shown in FIG. 3, because the cross-section of the above passivation wall 3 is the trapezoid, the cross-section of the electrode strip 21 formed by being attached to the passivation wall 3 is not a rectangle but a parallelogram which has an inclination angle same with a base angle of the trapezoid.

For instance, in the direction perpendicular to the surface 01A of the base substrate 01, a size of the passivation wall 3 of each electrode group 22 is the same with a size of the second electrode 2. That is to say, a thickness of the passivation wall 3 (may also be referred as height in FIG 3) is the same with a thickness of the second electrode 2. If the thickness of the passivation wall 3 is less than that of the second electrode 2, the electrode strips 21 with accurate size are uneasy to be formed; and if the thickness of the passivation wall 3 is greater than that of the second electrode 2, the material for forming the passivation wall 3 is wasted.

For instance, in the direction parallel to the surface 01A of the base substrate 01, a width of the electrode strip 21 is 0.5 - 1.2 µm. For instance, in the direction parallel to the surface 01A of the base substrate 01, a distance between two electrode strips 21 in the electrode group is 1.8 - 3.4 µm. For instance, in the direction parallel to the surface 01A of the base substrate 01, a distance between adjacent electrode groups is 5.2 - 5.6 µm.

In the embodiments of the present disclosure, the distance between the two electrode strips 21 in the electrode group is also a width of the passivation wall 3. The distance between adjacent electrode groups is also the spacing between the adjacent electrode groups. For instance, a first electrode group is adjacent to a second electrode group, and the above spacing refers to: a size of a distance between an electrode strip, which is in the first electrode group and is close to the second electrode group, and another electrode strip, which is in the second electrode group and is close to the first electrode group, in a direction parallel to a plane where the second electrode is located and perpendicular to the electrode strip 21.

It should be noted that the sizes, the thicknesses and the like of structural layers as shown in the accompanying drawings are only illustrative. In technical realization, the projection areas of the structural layers on the base substrate may be same or may be different. For instance, the required projection areas of the structural layers can be realized by etching process. Meanwhile, the structures as shown in the accompanying drawings also do not limit the geometrical shapes of the structural layers, for instance, the structures may have the shapes as shown in the figures, or may be trapezoid, or may be other shapes, and can also be realized by etching.

The embodiments of the present disclosure herein provide an array substrate with illustrative size: as shown in FIG. 4, in each electrode group 22, the width h1 of each electrode strip is 0.5 µm; a width of a surface that is included by the passivation wall 3 and contacts the insulating layer 4 below the passivation wall 3 is h2 which is 2 µm; and a width h3 of the spacing, namely a gap, between two adjacent electrode groups 22 is 5 µm.

Comparative example: the comparative example is the ADS array substrate shown in FIG. 1; FIG. 5 shows the dimensioning on the ADS array substrate shown in FIG. 1; the horizontal electric field is formed by the pixel electrode 2' and the common electrode 1'; and the electric field is adopted to drive the liquid crystal molecules to deflect, so as to form the display image. The width h4 of the pixel electrode strip of the pixel electrode 2' is 2.6 µm, and the spacing h5 between two pixel electrode strips is 5.4 µm.

FIG. 6 shows the fringe electric field distribution of the pixel electrode strips included by the pixel electrode 2' in the comparative example. As can be seen from FIG. 6: the horizontal component Ey of the electric field is strong at edge positions of the pixel electrode strips and is weak at both the middle portions of the pixel electrode strips and the intermediate positions between adjacent pixel electrode strips 2'; the vertical component Ez of the electric field exists simultaneously, the most strong point of Ez is at the middle portions of the pixel electrode strips, and the most weak point of the Ez is at the edge positions of the pixel electrode strips.

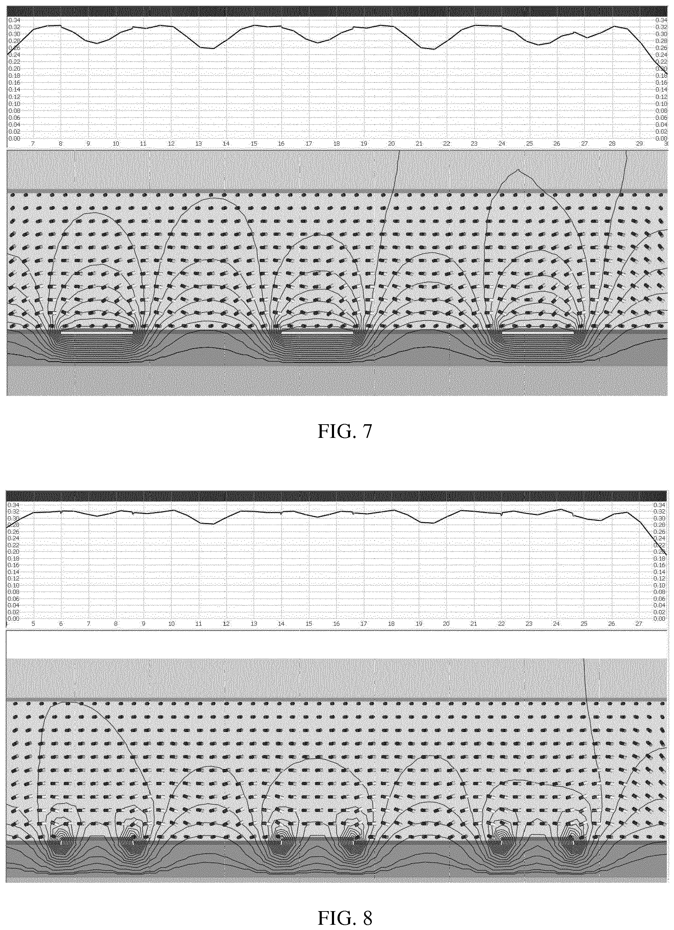

In the situation where the first electrode 1 is the common electrode and the second electrode 2 is the pixel electrode in the array substrate provided by the embodiment of the present disclosure, the array substrate provided by the embodiment of the present disclosure and the array substrate in the comparative example adopt TechWiz 2D software for simulation; the simulation data is: LC MAT-09-1284; the simulation result is shown in FIGS. 7 and 8, in which FIG 7 illustrates a simulation result of the comparative example and FIG 8 illustrates a simulation result of the embodiment of the present disclosure; and a horizontal coordinate in FIGS. 7 and 8 represents actual simulation region, and a vertical coordinate represents transmittance.

The following simulation result can be seen from FIGS. 7 and 8.

The maximum torsional angle in FIG 7 of the comparative example is near bottom surfaces at the edges of the pixel electrode strips, and the transmittance changes along with the position variation of the pixel electrode strips: the transmittance is maximum at the edge positions of the pixel electrode strips, and the light transmittance is very low at both the middle portions of the pixel electrode strips and the intermediate positions between adjacent pixel electrode strips. That is to say, the electric field at the middle position of a single pixel electrode strip and the electric field between adjacent pixel electrode strips affects the deflection range of the liquid crystal molecules and the deflection angle of the liquid crystal molecules, the transmittance is minimum at the above positions, and the torsional angle of liquid crystals at the intermediate position between the adjacent pixel electrode strips is only 20-30°.

In the embodiment of the present disclosure: the electrode group 22 is divided into two small wall type electrode strips 21; the passivation wall 3 eliminates the vertical component Ez of the electric field at the middle portion of the pixel electrode strip as shown in FIG 1; two new small electric fields with dense electric field lines are formed between two electrode strips 21 in the same electrode group 22 and the first electrode in a lower layer; and the two small electric fields provide additional horizontal electric filed to enhance the overall electric field, so that the liquid crystals at a middle position of the passivation wall 3 rotate due to the additionally new horizontal electric field, thereby increasing the range of the rotated liquid crystal molecules and then improving the transmittance. In another aspect, due to the variation of patterns of the second electrode 2, Ez between two adjacent electrode groups 22 is weakened, so the severe adverse effect on the liquid crystal molecules caused by Ez is reduced, and then the transmittance is further improved.

The generation of the above different results is due to the change of the electrode structure. In the comparative example, Cst (the storage capacitance) = positive Cst (70%) + side Cst (30%). In the embodiment of the present disclosure, the positive Cst is greatly reduced, so Cst = positive Cst (40%) + side Cst (30%); Cst is reduced by about 30%, so that both the charging time and the charging rate of the array substrate are greatly improved, the transmittance is improved by more than 4%, and thus the display quality is improved.

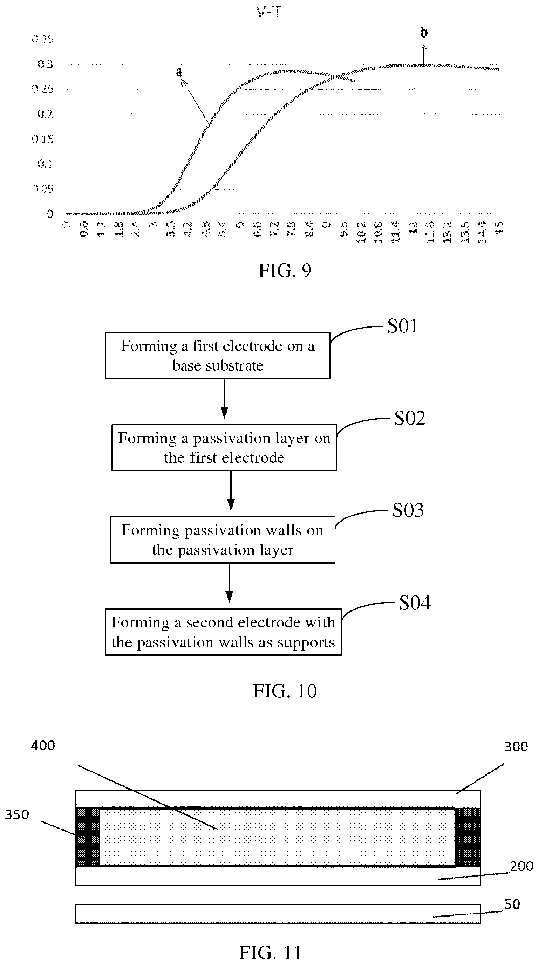

FIG 9 is a VT curve (voltage-transmittance curve) comparison chart of the embodiment of the present disclosure and the comparative example, in which a refers to the transmittance (Tr) of the comparative example, and b refers to the Tr of the embodiment of the present disclosure; in the figure, the maximum of the a curve is 0.285745, and the maximum of the b curve is 0.297947, and thus the Tr is improved by 4.27%.

At least one embodiment of the present disclosure provides a manufacturing method of the array substrate as shown in FIG 2. As shown in FIG 10, the manufacturing method includes the following steps S01 to S04.

S01: forming the first electrode 1 on the base substrate, in which the first electrode 1 is an integral plate electrode, for example.

For instance, a material of the first electrode 1 is indium tin oxide (ITO), indium zinc oxide (IZO) or similar transparent conductive material.

S02: forming the insulating layer 4 on the first electrode 1.

For instance, one patterning process is adopted to form patterns of the insulating layer and electrode contact through holes thereof.

For instance, in the step, the patterning process includes: depositing a passivation film (for instance, a material of the passivation film includes SixNy or SixOy, namely silicon nitride or silicon oxide, or other inorganic insulating materials or organic insulating materials); coating a photoresist on the passivation film; exposing the photoresist at corresponding regions for forming the patterns of the electrode contact through holes, and performing development and postbaking on the exposed photoresist; forming the electrode contact through holes by etching; and finally stripping off the photoresist.

S03: forming the passivation wall 3 on the insulating layer 4.

The step S03 is similar to the step S02. No further description will be given here. For instance, the material of the passivation wall 3 may be the same with or different from that of the insulating layer 4.

For instance, the step S02 and the step S03 can be formed via the same mask. For instance, the insulating layer 4 and the passivation wall 3 are formed by half-tone mask process. In this case, for instance, both the material of the insulating layer 4 and the material of the passivation wall 3 may select SixNy, SixOy or similar insulating materials.

S04: forming the second electrode 2 including the plurality of electrode strips 21 by the support of the passivation wall 3.

For instance, the pattern of the second electrode is formed by one patterning process. For instance, the step S04 includes: depositing a second electrode film (for instance, the material thereof includes ITO, IZO or similar transparent conductive material); coating a photoresist on the second electrode film; exposing the photoresist on the second electrode film, and performing development and postbaking on the exposed photoresist; etching the second electrode film to form the second electrode 2 including the plurality of electrode strips 21; stripping off the photoresist; and subsequently performing annealing.

In the manufacturing method provided by the embodiments of the present disclosure, one of the first electrode 1 and the second electrode 2 is the pixel electrode and the other one of the first electrode 1 and the second electrode is the common electrode.

For instance, in the manufacturing method provided by the embodiments of the present disclosure, in the direction perpendicular to the surface 01A that is included by the base substrate 01 and faces the insulating layer 4, the first electrode 1 is disposed between the base substrate 01 and the second electrode 2; and in the same electrode group 22, the arrangement direction of the electrode strips 21 and the passivation wall 3 is parallel to the surface 01A of the base substrate 01 and there are overlap regions between the orthographic projections of the electrode strips 21 on the base substrate and the orthographic projection of the passivation wall 3 on the base substrate 01.

At least one embodiment of the present disclosure provides a display device, which includes a display panel. As shown in FIG. 11, the display panel includes an opposite substrate 300, the array substrate 200 provided by any foregoing embodiment, and liquid crystals 400 disposed between the opposite substrate 300 and the array substrate 200; and the array substrate 200 and the opposite substrate 300 are connected with each other through a sealant frame 350.

For instance, the opposite substrate 300 is a color filter substrate including a color filter layer.

In some embodiments, the display device further includes a backlight source 50 for providing backlight to the array substrate 200.

For instance, the display device may be any product or component with a display function such as a liquid crystal display panel, an e-paper, a mobile phone, a tablet PC, a television, a display, a notebook computer, a digital album or a navigator.

In the embodiments of the present disclosure, the array substrate includes the first electrode, the second electrode and the insulating layer disposed between the first electrode and the second electrode; the second electrode includes the plurality of electrode groups; the electrode group includes electrode strips and the passivation wall sandwiched between the electrode strips; the vertical component Ez of the electric field at the position of the passivation wall is weak, and the vertical component Ez of the electric field between adjacent electrode groups is also weak; and the electrode strips respectively formed on inclined surfaces of the passivation wall enhance the horizontal electric filed at the positions of the electrode strips, so the deflection angle of the liquid crystals is increased, and then the transmittance is improved. The array substrate provided by the present disclosure is applicable to various display devices and is particularly applicable to ADS display products.

The above embodiments regarding the array substrate, the manufacturing method thereof and the display device can be referred to each other, and the repeated portions are not described again.

What are described above is related to the illustrative embodiments of the disclosure only and not limitative to the scope of the disclosure; the scopes of the disclosure are defined by the accompanying claims.

## Claims

1. An array substrate, comprising:
a base substrate;
a first electrode and a second electrode which are on the base substrate, wherein one of the first electrode and the second electrode is a pixel electrode and the other one of the first electrode and the second electrode is a common electrode; and
an insulating layer between the first electrode and the second electrode,
wherein the second electrode comprises a plurality of electrode groups, and each of the plurality of electrode groups comprises electrode strips and an insulated passivation wall sandwiched between the electrode strips.

2. The array substrate according to claim 1, wherein
in a direction perpendicular to a surface that is comprised by the base substrate and faces the insulating layer, the first electrode is between the base substrate and the second electrode; and
in a same electrode group among the plurality of electrode groups, an arrangement direction of the electrode strips and the passivation wall is parallel to the surface of the base substrate and overlap regions are between orthographic projections of the electrode strips on the base substrate and an orthographic projection of the passivation wall on the base substrate.

3. The array substrate according to claim 1 or 2, wherein included angles are between a plane where the base substrate is located and surfaces where the electrode strips contact the passivation wall in each of the plurality of electrode groups, and the included angles are acute angles.

4. The array substrate according to any one of claims 1 to 3, wherein in a same electrode group among the plurality of electrode groups, the passivation wall comprises inclined lateral surfaces respectively covered by the electrode strips, and the inclined lateral surfaces of the same passivation wall have different inclination directions.

5. The array substrate according to any one of claims 1 to 4, wherein the electrode strips in a same electrode group among the plurality of electrode groups are disconnected from each other on a top of the passivation wall; and the top of the passivation wall is an end which is comprised by the passivation wall and faces away from the base substrate.

6. The array substrate according to claim 5, wherein the electrode strips in the same electrode group are directly electrically connected with each other.

7. The array substrate according to claim 5, wherein the electrode strips in the same electrode group are electrically connected with each other through a conductive structure.

8. The array substrate according to any one of claims 1 to 7, wherein a concave space is between adjacent passivation walls that adjacent electrode groups among the plurality of electrode groups respectively comprise.

9. The array substrate according to claim 8, wherein adjacent electrode strips that the adjacent electrode groups respectively comprise are disconnected from each other in the concave space.

10. The array substrate according to any one of claims 1 to 9, wherein the second electrode comprises a surface close to the base substrate and another surface away from the base substrate which have a same width.

11. The array substrate according to any one of claims 1 to 10, wherein cross-sections of the electrode strips are in a shape of a parallelogram in a direction perpendicular to the base substrate and in a direction perpendicular to an extension direction of the second electrode which is in a shape of strips.

12. The array substrate according to any one of claims 1 to 11, wherein in a direction perpendicular to the base substrate, a size of the passivation wall of each of the plurality of electrode groups is the same with a size of each of the electrode strips.

13. The array substrate according to any one of claims 1 to 12, wherein in a direction parallel to a surface that is comprised by the base substrate and faces the insulating layer, a width of each of the electrode strips is 0.5 - 1.2 µm.

14. The array substrate according to any one of claims 1 to 13, wherein a distance between the electrode strips adjacent to each other in a same electrode group among the plurality of electrode groups is 1.8 - 3.4 µm.

15. The array substrate according to any one of claims 1 to 14, wherein a distance between adjacent electrode groups among the plurality of electrode groups is 5.2 - 5.6 µm.

16. The array substrate according to any one of claims 1 to 15, wherein the insulating layer and the passivation wall form a one-piece structure.

17. A display device, comprising an opposite substrate, the array substrate according to any one of claims 1 to 16, and liquid crystals between the opposite substrate and the array substrate.

18. A manufacturing method of an array substrate, comprising:
forming a first electrode on a base substrate;
forming an insulating layer on the first electrode; and
forming a second electrode on the insulating layer, wherein one of the first electrode and the second electrode is a pixel electrode and the other one of the first electrode and the second electrode is a common electrode; the second electrode comprises a plurality of electrode groups, and each of the plurality of electrode groups comprises electrode strips and a passivation wall sandwiched between the electrode strips.

19. The manufacturing method according to claim 18, wherein
in a direction perpendicular to a surface that is comprised by the base substrate and faces the insulating layer, the first electrode is between the base substrate and the second electrode; and
in a same electrode group among the plurality of electrode groups, an arrangement direction of the electrode strips and the passivation wall is parallel to the surface of the base substrate and overlap regions are between orthographic projections of the electrode strips on the base substrate and an orthographic projection of the passivation wall on the base substrate.
